# FASCICULE DE BREVET EUROPEEN

(11) **EP 0 858 166 B1**
(45) Date de publication et mention de la délivrance du brevet: **30.08.2000**
(21) Numéro de dépôt: 97400274.3
(22) Date de dépôt: 07.02.1997
(51) Int. Cl.: H03K 17/96

(54) **Clavier étanche et appareil de cuisson comportant un tel clavier**
Abgedichtete Tastatur und ein solche aufweisendes Kochgerät
Sealed keyboard and cooking appliance incorporating the same

(43) Date de publication de la demande: 12.08.1998
(73) Titulaire: Jaeger Regulation Société Anonyme, 28000 Chartres (FR)
(72) Inventeur: Douville, Eric, 28000 Chartres (FR)
(74) Mandataire: Cabinet HERRBURGER

(56) Documents cités:
- EP-A- 0 603 039
- EP-A- 0 688 102
- FR-A- 2 374 811
- FR-A- 2 704 332
- FR-A- 2 739 233

## Description

La présente invention se rapporte à un clavier, de préférence étanche, et aux appareils, notamment de cuisson, comportant un tel clavier.

Les appareils domestiques ou industriels sont fréquemment commandés par des claviers étanches pour éviter les agressions en environnement sévère ou pour protéger le milieu contre un risque d'explosion ou de pollution résultant du fonctionnement du clavier.

EP-A-0 603 039 décrit un clavier étanche dont chaque touche comporte un émetteur de rayonnement radioélectrique haute fréquence connecté à une antenne d'émission, ainsi qu'une antenne de réception connectée à un récepteur, les signaux transmis entre les antennes d'émission et de réception étant atténués par la présence d'un doigt de l'opérateur au droit de la touche. L'antenne d'émission de chaque touche est sérigraphiée sur une première face d'un circuit imprimé, l'antenne de réception étant sérigraphiée en vis-à-vis sur la face opposée de ce circuit. Le circuit imprimé double face était disposé à proximité d'une paroi d'étanchéité, notamment d'une plaque vitrocéramique.

Bien que donnant généralement satisfaction, ce clavier présente des inconvénients. Sa sensibilité varie avec la distance entre la paroi d'étanchéité et le circuit imprimé. Une grande précision de montage du circuit imprimé sur le châssis d'un appareil, augmentant significativement le prix de revient de l'appareil, est nécessaire pour conserver une distance entre le circuit imprimé et la paroi d'étanchéité et par suite pour que tous les claviers produits et toutes les touches de chaque clavier aient la même sensibilité.

Un clavier suivant le préambule de la revendication 1 est connu du document FR-A-2 704 332.

II est habituel de disposer des voyants ou des afficheurs, notamment à diode électroluminescente (LED en terminologie anglo-saxonne) à proximité des touches du clavier de commande. L'épaisseur des boîtiers des diodes électroluminescentes ou des afficheurs à diodes électroluminescentes empêche leur montage sur le circuit imprimé muni d'antennes, et par suite requiert la mise en oeuvre d'un circuit imprimé supplémentaire, ce qui complique l'assemblage et augmente le prix de revient. Cette augmentation du prix de revient est accentuée par la mise en oeuvre des circuits imprimés double face qui, de plus, ne peuvent pas s'adapter à toutes les configurations des appareils à équiper d'un clavier de commande.

C'est par conséquent un but de la présente invention d'offrir un clavier, de préférence étanche, ayant une sensibilité constante.

C'est également un but de la présente invention d'offrir un tel clavier présentant de grandes tolérances de montage.

C'est aussi un but de la présente invention d'offrir un clavier simple et fiable.

C'est également un but de la présente invention d'offrir un clavier susceptible d'être facilement adapté à la géométrie des divers appareils à commander.

C'est aussi un but de la présente invention d'offrir un tel clavier ayant un faible prix de revient.

Ces buts sont atteints selon l'invention par un clavier comportant un circuit imprimé muni d'une antenne d'émission connectée à un générateur haute fréquence ou à un générateur radiofréquence et une antenne de réception connectée à un circuit de détection. Au moins une desdites antennes, avantageusement l'antenne de réception, est connectée à un élément saillant, de préférence élastique, disposé sensiblement perpendiculairement au circuit imprimé pour être appliqué sur une face interne d'une paroi d'étanchéité au droit de l'emplacement de détection de la présence d'un doigt sur une touche du clavier.

Avantageusement, les antennes d'émission et de réception sont disposées sur la même face du circuit imprimé.

L'invention a principalement pour objet un clavier, notamment étanche, comportant au moins une touche comprenant un élément saillant conducteur s'étendant jusqu'à la proximité d'une zone de réception d'un doigt appuyant sur la touche, caractérisé en ce qu'il comporte, en outre, une antenne d'émission connectée à un générateur haute fréquence ou à un générateur radiofréquence et une antenne de réception connectée à un récepteur, lesdites antennes comportant des pistes d'un circuit imprimé et en ce que ledit élément saillant est connecté à l'une desdites antennes.

L'invention a également pour objet un clavier, caractérisé en ce que l'élément saillant est connecté à l'antenne de réception.

L'invention a également pour objet un clavier, caractérisé en ce que l'élément saillant comporte un ressort s'étendant sensiblement perpendiculairement au circuit imprimé.

L'invention a également pour objet un clavier, caractérisé en ce que les pistes du circuit imprimé de l'antenne d'émission et les pistes du circuit imprimé de l'antenne de réception se trouvent sur la même face dudit circuit imprimé.

L'invention a également pour objet un clavier, caractérisé en ce que le circuit imprimé est un circuit monocouche.

L'invention a également pour objet un clavier, caractérisé en ce que les pistes du circuit imprimé de l'antenne d'émission entourent sensiblement les pistes du circuit imprimé de l'antenne de réception.

L'invention a également pour objet un clavier, caractérisé en ce qu'il comporte des moyens d'affichage, notamment à diode électroluminescente, solidarisés avec le circuit imprimé.

L'invention a également pour objet un appareil ménager, caractérisé en ce qu'il comporte un clavier de commande selon l'invention.

L'invention a également pour objet un appareil ménager, caractérisé en ce que ledit appareil est une table de cuisson vitrocéramique et en ce que les éléments saillants conducteurs s'étendent jusqu'aux zones de la face interne d'une plaque vitrocéramique en vis-à-vis des zones de réception d'un doigt appuyant sur la touche correspondante.

L'invention sera mieux comprise au moyen de la description ci-après et des figures annexées données comme des exemples non limitatifs et sur lesquels :
- la figure 1 comporte deux vues en coupe d'un dispositif de type connu ;
- la figure 2 comporte deux vues en coupe de l'exemple préféré de réalisation du dispositif selon la présente invention ;
- la figure 3 est une vue en coupe d'une variante de réalisation du dispositif selon la présente invention ;
- la figure 4 est une vue en coupe d'une autre variante du dispositif selon l'invention ;
- la figure 5 est un schéma électrique de l'exemple préféré de réalisation du dispositif selon la présente invention ;
- la figure 6 est une courbe illustrant la variation de la tension de sortie du dispositif de la figure 4 en fonction du temps.

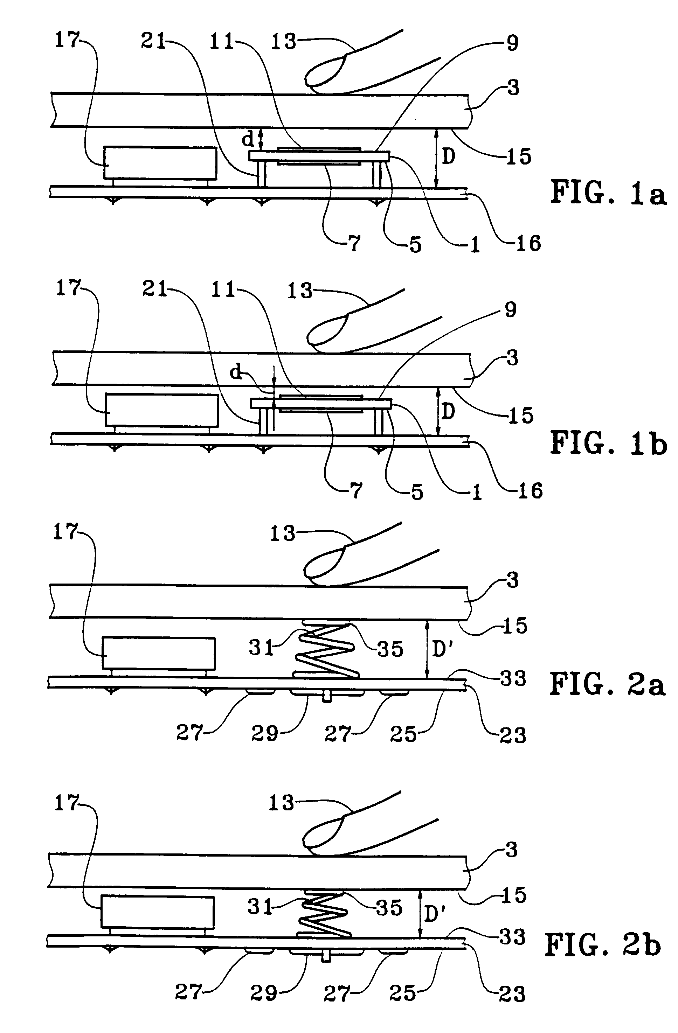

Sur les figures 1 à 6, on a utilisé les mêmes références pour désigner les mêmes éléments.

Sur la figure 1, on peut voir un circuit imprimé 1 disposé derrière une paroi d'étanchéité 3, notamment une plaque vitrocéramique d'un appareil de cuisson domestique, portant, sur une première face principale 5, une antenne d'émission 7 et, sur une face opposée 9 du circuit imprimé 1, une antenne de réception 11 formant une touche d'un clavier étanche permettant de détecter la présence d'un doigt 13. La construction d'un clavier sensible exige que la distance d entre la face 9 du circuit imprimé 1 et une face 15 de la paroi d'étanchéité 3 disposée en vis-à-vis, soit faible, empêchant le montage sur le circuit imprimé 1 des dispositifs d'affichage 17 à diode électroluminescente montés dans des boîtiers standards.

Dans l'exemple illustré sur la figure 1, un second circuit imprimé 16 porte le dispositif d'affichage 17 ainsi que le circuit imprimé 1 monté sur des espaceurs 21, par exemple sur des plots permettant de rapprocher l'antenne de réception 11 de la paroi d'étanchéité 3. Le second circuit imprimé 16 est habituellement monté sur le châssis (non représenté) de l'appareil de cuisson. L'imprécision du montage ne permet pas de maintenir une distance D constante entre le circuit imprimé 16 et la paroi d'étanchéité 3 et par suite la distance d entre la face 9 du circuit imprimé 1 et la face 15 de la paroi d'étanchéité 3. Il en résulte que chaque clavier a une sensibilité différente ou même que la sensibilité des diverses touches d'un même clavier n'est pas toujours constante. Dans l'exemple illustré sur la figure 1a, les distances D et d sont supérieures à celles de l'exemple illustré sur la figure 1b.

Sur la figure 2, on peut voir l'exemple préféré de réalisation du clavier selon la présente invention comportant un unique circuit imprimé 23 disposé parallèlement à une paroi d'étanchéité 3, par exemple à une plaque vitrocéramique d'un appareil de cuisson. Une face principale 25 du circuit imprimé 23 opposée à la paroi d'étanchéité 3 porte pour chaque touche du clavier (une seule étant représentée sur chaque dessin de la figure 2) une antenne d'émission 27 entourant une antenne de réception 29. L'antenne de réception 29 est connectée, par exemple, par l'intermédiaire d'un trou métallisé non représenté, à un élément saillant conducteur et élastique 31 disposé entre une seconde face principale 33 du circuit 23 et la face 15 de la paroi d'étanchéité 3. Avantageusement, l'élément saillant 31 s'étend sensiblement normalement au plan du circuit imprimé 23. L'élasticité de l'élément saillant d'antenne 31 permet d'appliquer une de ses extrémités 35 sur la face 15 de la paroi d'étanchéité 3 indépendamment de la distance D' séparant le circuit imprimé 23 de ladite face 15 et permet ainsi de compenser d'éventuelles imprécisions de montage du circuit imprimé 23 sur un éventuel châssis. Ainsi, la sensibilité du clavier de la figure 2a pour lequel la distance D' est relativement grande, est égale à celle du clavier illustré sur la figure 2b pour lequel cette distance D' est plus faible. Toutefois, dans tous les cas, cette distance est suffisante pour permettre d'implanter le dispositif d'affichage 17 sur le circuit 23, ce qui permet d'éviter la mise en oeuvre de circuits multiples et permet de réduire le coût de revient.

Il est bien entendu que la présente invention n'est pas limitée à la mise en oeuvre des ressorts métalliques, notamment en fer ou alliage de fer, en tant qu'éléments saillants 31. On peut par exemple sans sortir du cadre de la présente invention mettre en oeuvre des rubans conducteurs, comme par exemple des rubans métalliques élastiques ou des pistes conductrices d'un circuit imprimé souple.

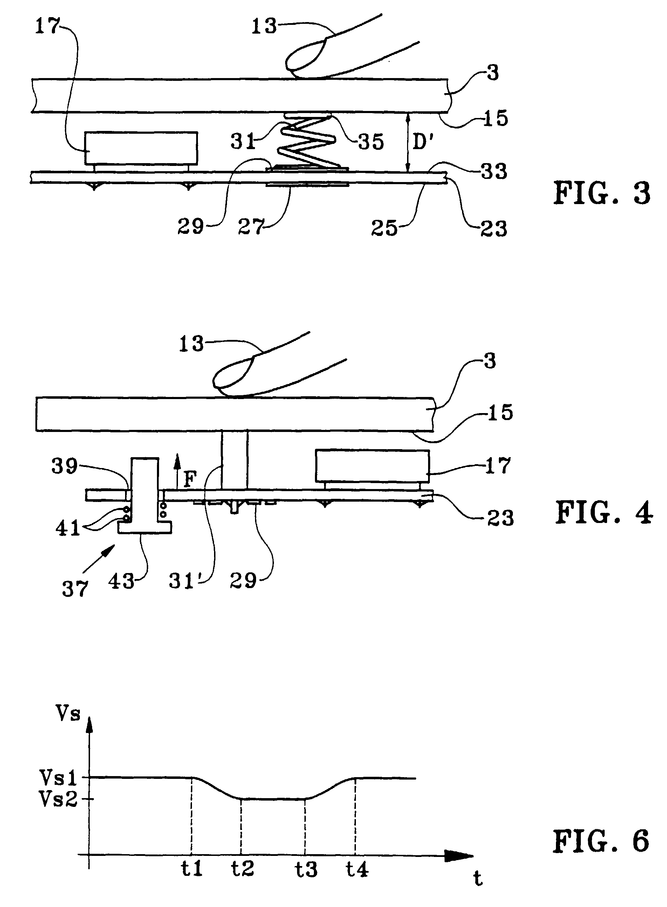

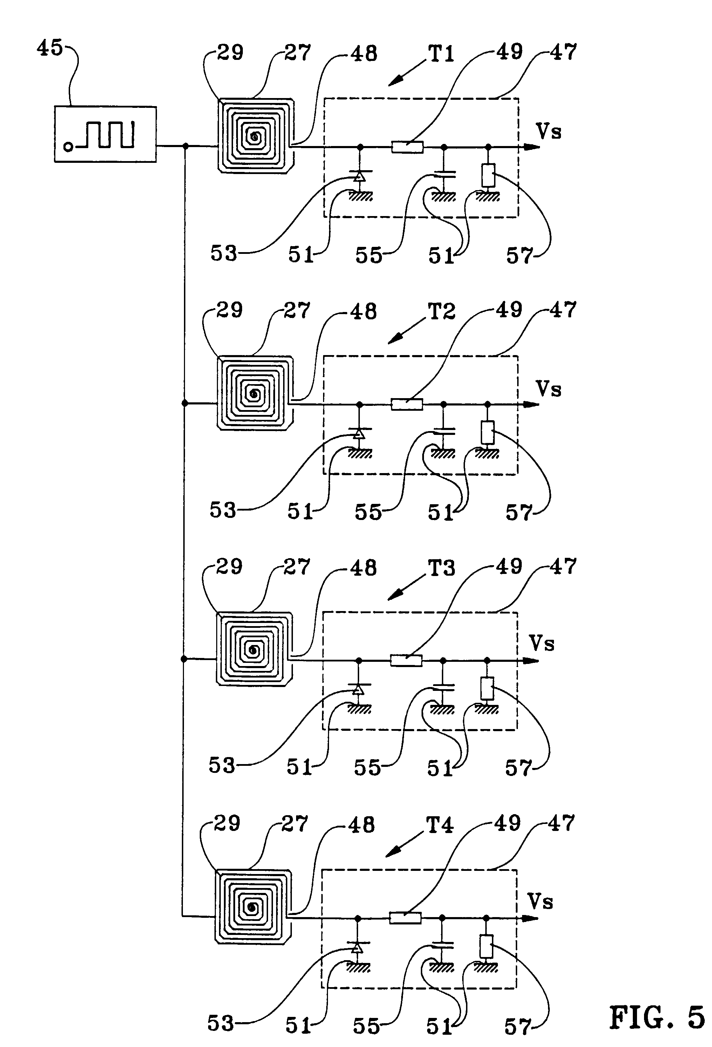

De même, la présente invention n'est pas limitée à la mise en oeuvre de circuits 23 simples faces mais au contraire s'étend aux circuits multicouches ou au circuit double face dont un exemple est illustré sur la figure 3. Dans cet exemple de réalisation, l'antenne d'émission 27 est disposée sur la face 25 du circuit imprimé 23 alors que l'antenne de réception 29 est disposée sur la face 33 du circuit imprimé 23 située en vis-à-vis de la face 15 de la paroi d'étanchéité 3. L'élément saillant conducteur élastique 31 est connecté à l'antenne 29, par exemple par soudure. Cette soudure peut également assurer sa solidarisation avec le circuit imprimé 23. En variante, la solidarisation est assurée par d'autres moyens (non représentés), comme par exemple par collage ou clipsage.

Dans la variante de réalisation du clavier selon la présente invention illustré sur la figure 4, le circuit imprimé 23 est monté flottant sur un support 37. Dans l'exemple de réalisation illustré, l'antenne de réception 29 est connectée à un élément saillant conducteur rigide 31' s'étendant en direction de la face 15 de la paroi d'étanchéité 3. La hauteur des éléments saillants conducteurs 31' ménage un espace suffisant sur le circuit imprimé 23 pour le montage des dispositifs d'affichage 17. Dans l'exemple de réalisation illustré sur la figure 4, les moyens 37 comportent des plots cylindriques d'axes orthogonaux au circuit imprimé 23 et à la paroi d'étanchéité 3 passant dans des ouvertures 39 ménagées dans le circuit imprimé 23. Un ressort à boudin 41 entourant le plot cylindrique et reposant sur un épaulement 43 exerce sur le circuit imprimé 23 une force F dirigée vers la paroi d'étanchéité 3 et provoque l'appui des éléments saillants conducteurs 31' sur la face 15 de ladite paroi d'étanchéité. Les ressorts 41 permettent de rattraper le jeu éventuel de montage des éléments 37 sur le châssis de l'appareil de cuisson.

Sur la figure 5, on peut voir le schéma d'un exemple de clavier selon la présente invention comportant quatre touches T1 à T4. Il est bien entendu que la mise en oeuvre de claviers comportant un nombre quelconque de touches ne sort pas du cadre de la présente invention. Chaque touche comporte une antenne d'émission 27 reliée à un générateur radiofréquence 45, par exemple à un générateur de signaux carrés ou sinusoïdaux dont la tension varie entre 0 et 24 V, à une fréquence comprise entre 100 kHz et 300 kHz, de préférence entre 140 kHz et 220 kHz, par exemple une fréquence sensiblement égale à 200 kHz.

Chaque antenne d'émission 27 est associée à une antenne de réception 29 connectée à un récepteur 47. Dans l'exemple avantageux illustré, l'antenne d'émission 27 a une forme sensiblement rectangulaire comprenant une discontinuité 48 de passage de la connexion de l'antenne de réception 29 au récepteur 47. L'antenne de réception 29 a, par exemple, la forme d'une spirale carrée ou rectangulaire à angles coupés. Les antennes d'émission 27 et de réception 29 peuvent bien entendu avoir des configurations différentes, comme par exemple une spirale circulaire. L'entrée du récepteur 47 est reliée à sa sortie par une résistance 49, par exemple de 22 kΩ. La masse 51 est reliée à l'entrée du récepteur par une diode 53, par exemple de type 1N 4 1, 4 8. La masse 51 est reliée à la sortie du récepteur 47, en parallèle par un condensateur 55, par exemple de 100 nF et par une résistance 57, par exemple de 220 kΩ. En sortie de chaque récepteur 47, on dispose d'une tension Vs caractéristique de l'état de la touche du clavier correspondant.

Avantageusement, le clavier de la figure 5 comporte un circuit imprimé monocouche muni, en outre, d'éléments 31 et de dispositifs d'affichage 17 (non représentés) sur la figure 5.

Sur la figure 6, on peut voir la variation de la tension Vs en fonction du temps lorsqu'on applique un doigt 13 sur une touche du clavier de la figure 5. Soit t1, le temps d'application d'un doigt 13 sur la touche et t3 le temps où on retire le doigt. Antérieurement à t1, la tension Vs est égale à Vs1, par exemple égale à 1,2 V.

Entre t1 et t2, la tension Vs baisse de Vs1 à une valeur Vs2, par exemple égale à 1 V. Entre t2 et t3, la tension Vs est une constante égale à Vs2. Entre t3 et t4, la tension remonte de Vs2 à Vs1. t2 - t1 est par exemple comprise entre 1 ms et 5 ms, et t4 - t3 est par exemple comprise entre 4 ms et 5 ms.

Il est bien entendu que la présente invention n'est pas limitée au circuit imprimé 23 plan mais s'étend également au circuit imprimé conformé à une paroi non nécessairement plane d'un produit ou directement imprimé sur la face interne d'une paroi isolante d'un produit ainsi qu'à la mise en oeuvre de circuits souples. De même, la présente invention n'est pas limitée à la mise en oeuvre d'éléments saillants conducteurs 31 mais s'étend également à tout circuit imprimé monocouche comportant, pour chaque touche du clavier, sur une même face du circuit, une antenne d'émission et l'antenne de réception correspondante.

La présente invention s'applique notamment à la réalisation de claviers étanches pour environnement sévère ainsi que pour les appareils domestiques.

La présente invention s'applique principalement aux claviers de commande de tables de cuisson comportant une plaque vitrocéramique.

## Revendications

1. Clavier, notamment étanche, comportant au moins une touche (T1, T2, T3, T4) comprenant un élément saillant (31, 31') conducteur s'étendant jusqu'à la proximité d'une zone de réception d'un doigt appuyant sur la touche, caractérisé en ce qu'il comporte, en outre, une antenne d'émission (27) connectée à un générateur haute fréquence ou à un générateur radiofréquence (45) et une antenne de réception (29) connectée à un récepteur (47), lesdites antennes comportant des pistes d'un circuit imprimé (23) et en ce que ledit élément saillant (31, 31') est connecté à l'une desdites antennes.

2. Clavier selon la revendication 1, caractérisé en ce que l'élément saillant (31, 31') est connecté à l'antenne de réception (27).

3. Clavier selon la revendication 1 ou 2, caractérisé en ce que l'élément saillant (31, 31') comporte un ressort s'étendant sensiblement perpendiculairement au circuit imprimé (23).

4. Clavier selon la revendication 1, 2 ou 3, caractérisé en ce que les pistes du circuit imprimé (23) de l'antenne d'émission (27) et les pistes du circuit imprimé (23) de l'antenne de réception (29) se trouvent sur la même face dudit circuit imprimé (23).

5. Clavier selon l'une quelconque des revendications 1 à 4, caractérisé en ce que le circuit imprimé (23) est un circuit monocouche.

6. Clavier selon la revendication 4 ou 5, caractérisé en ce que les pistes du circuit imprimé (23) de l'antenne d'émission (27) entourent sensiblement les pistes du circuit imprimé (23) de l'antenne de réception.

7. Clavier selon l'une quelconque des revendications précédentes, caractérisé en ce qu'il comporte des moyens d'affichage (17), notamment à diode électroluminescente, solidarisés avec le circuit imprimé (23).

8. Appareil ménager, caractérisé en ce qu'il comporte un clavier de commande selon l'une quelconque des revendications précédentes.

9. Appareil ménager selon la revendication 8, caractérisé en ce que ledit appareil est une table de cuisson vitrocéramique et en ce que les éléments saillants conducteurs (31) s'étendent jusqu'aux zones de la face interne (15) d'une plaque vitrocéramique (3) en vis-à-vis des zones de réception d'un doigt (13) appuyant sur la touche correspondante.

## Patentansprüche

1. Tastatur, insbesondere abgedichtete, mit mindestens einer Taste (T1, T2, T3, T4), die ein leitendes, hervorspringendes Element (31,31') umfaßt, das sich bis in die Nähe einer Aufnahmezone eines auf die Taste drückenden Fingers erstreckt, gekennzeichnet durch eine Sendeantenne (27), die mit einem Hochfrequenzgenerator oder einem Radiofrequenzgenerator (45) verbunden ist und eine Empfangsantenne (29) aufweist, die mit einem Empfänger (47) verbunden ist, wobei die genannten Antennen die Leiterbahnen einer gedruckten Schaltung (23) umfassen und das genannte hervorspringende Element (31,31') mit einer der genannten Antennen verbunden ist.

2. Tastatur nach Anspruch 1, dadurch gekennzeichnet, daß das hervorspringende Element (31,31') mit der Empfangsantenne (27) verbunden ist.

3. Tastatur nach Anspruch 1 oder 2, dadurch gekennzeichnet, daß das hervorspringende Element (31,31') eine Feder beinhaltet, die sich im wesentlichen senkrecht zu der gedruckten Schaltung erstreckt.

4. Tastatur nach Anspruch 1, 2 oder 3, dadurch gekennzeichnet, daß sich die Leiterbahnen der gedruckten Schaltung (23) der Sendeantenne (27) und die Leiterbahnen der gedruckten Schaltung (23) der Empfangsantenne (29) auf derselben Seite der genannten gedruckten Schaltung (23) befinden.

5. Tastatur nach einem der Ansprüche 1 bis 4, dadurch gekennzeichnet, daß die gedruckte Schaltung (23) eine einlagige Schaltung ist.

6. Tastatur nach Anspruch 4 oder 5, dadurch gekennzeichnet, daß die Leiterbahnen der gedruckten Schaltung (23) der Sendeantenne (27) die Leiterbahnen der gedruckten Schaltung (23) der Empfangsantenne im wesentlichen umgeben.

7. Tastatur nach einem der vorhergehenden Ansprüche, gekennzeichnet durch Anzeigemittel (17), insbesondere als lichtemittierende Diode, die mit der gedruckten Schaltung (23) verbunden sind.

8. Haushaltsgerät, dadurch gekennzeichnet, daß es eine Bedientastatur nach einem der vorangegangenen Ansprüche aufweist.

9. Haushaltsgerät nach Anspruch 8, dadurch gekennzeichnet, daß das genannte Gerät ein glaskeramisches Kochfeld ist und daß die hervorspringenden leitenden Elemente (31) sich bis in die Bereiche der Innenseite (15) einer glaskeramischen Platte (3) erstrecken, die den Bereichen der Aufnahme eines auf die entsprechende Taste drückenden Fingers (13) gegenüberliegen.

## Claims

1. Keyboard, especially a sealed keyboard, comprising at least one key (T1, T2, T3, T4) having a conductive projecting element (31, 31') extending as far as the vicinity of a region for receiving a finger pressing on the key, characterised in that it also comprises a transmitting aerial (27) connected to a high-frequency generator or to a radiofrequency generator (45), and a receiving aerial (29) connected to a receiver (47), the aerials comprising tracks of a printed circuit (23), and in that the projecting element (31, 31') is connected to one of the aerials.

2. Keyboard according to claim 1, characterised in that the projecting element (31, 31') is connected to the receiving aerial (27) .

3. Keyboard according to claim 1 or 2, characterised in that the projecting element (31, 31') comprises a spring extending substantially perpendicularly to the printed circuit (23) .

4. Keyboard according to claim 1, 2 or 3, characterised in that the tracks of the printed circuit (23) of the transmitting aerial (27) and the tracks of the printed circuit (23) of the receiving aerial (29) are arranged on the same face of the printed circuit (23).

5. Keyboard according to any one of claims 1 to 4, characterised in that the printed circuit (23) is a mono-layer circuit.

6. Keyboard according to claim 4 or 5, characterised in that the tracks of the printed circuit (23) of the transmitting aerial (27) substantially surround the tracks of the printed circuit (23) of the receiving aerial.

7. Keyboard according to any one of the preceding claims, characterised in that it comprises display means (17), especially having a light-emitting diode, that are formed integrally with the printed circuit (23).

8. Domestic appliance, characterised in that it comprises a control keyboard according to any one of the preceding claims.

9. Domestic appliance according to claim 8, characterised in that the appliance is a glass-ceramic cooking surface and in that the conductive projecting elements (31) extend as far as the regions of the internal face (15) of a glass-ceramic plate (3) that are opposite the regions for receiving a finger (13) pressing on the corresponding key.
